# FASCICULE DE BREVET EUROPEEN

(11) **EP 3 866 181 B1**
(45) Date de publication et mention de la délivrance du brevet: **23.04.2025**
(21) Numéro de dépôt: 21156852.2
(22) Date de dépôt: 12.02.2021
(51) Int. Cl.: H01G 4/33, H01G 4/08, H01G 4/005, B82Y 40/00, H01L 29/06, H01L 23/522

(54) **DISPOSITIF CAPACITIF**
KAPAZITIVE VORRICHTUNG
CAPACITIVE DEVICE

(30) Priorité: 14.02.2020 FR 2001481
(43) Date de publication de la demande: 18.08.2021
(73) Titulaire: Commissariat à l'Energie Atomique et aux Energies Alternatives, 75015 Paris (FR)
(72) Inventeur: CLARET, Thierry, 38054 GRENOBLE Cedex 09 (FR); FERREIRA, Delphine, 38054 GRENOBLE Cedex 09 (FR)
(74) Mandataire: Brevalex

(56) Documents cités:
- US-A1- 2006 214 262
- US-A1- 2008 003 768
- US-A1- 2008 197 399
- US-A1- 2011 100 793
- US-A1- 2013 250 479
- US-B1- 9 349 789
- RAMOS R ET AL: "Nanocarbon interconnects combining vertical CNT interconnects and horizontal graphene lines", 2016 IEEE INTERNATIONAL INTERCONNECT TECHNOLOGY CONFERENCE / ADVANCED METALLIZATION CONFERENCE (IITC/AMC), IEEE, 23 May 2016 (2016-05-23), pages 48 - 50, XP032920631, DOI: 10.1109/IITC-AMC.2016.7507676

## Description

### DOMAINE TECHNIQUE

La présente invention se rapporte au domaine des nanostructures et de leurs méthodes de fabrication. En particulier, la présente invention se rapporte à la mise en œuvre de nanotubes, et notamment de nanotubes de carbone, dans les dispositifs capacitifs.

À cet égard, la présente invention concerne un dispositif capacitif à haute densité qui comprend un empilement capacitif recouvrant de manière conforme un réseau de nanotubes. La configuration et/ou l'agencement du dispositif proposé dans le cadre de la présente invention permet de conférer à ce dernier une meilleure compacité au regard des dispositifs connus de l'état de la technique. Compte tenu de la configuration proposée, le procédé de fabrication du dispositif capacitif est également simplifié et permet de préserver l'intégrité des nanotubes.

### ÉTAT DE LA TECHNIQUE ANTÉRIEURE

Les capacités à haute densité font aujourd'hui l'objet d'intenses développements. Ces dernières comprennent notamment un empilement, dit empilement capacitif, pourvu de deux ou trois couches, et formé sur une surface ou une structure présentant un facteur de forme élevé afin de limiter l'encombrement desdites capacités.

À cet égard, les nanofils ou les nanotubes, et plus particulièrement les nanotubes de carbone, qui présentent un rapport surface/volume important, sont des candidats de choix pour la réalisation de ces structures à facteur de forme élevé. Plus particulièrement, dans le document [1] cité à la fin de la description, les auteurs proposent de former des faisceaux de nanotubes de carbone qui s'étendent perpendiculairement à une surface support et selon un agencement matriciel.

Un ensemble d'étapes technologiques peut ensuite être exécuté afin d'obtenir un dispositif capacitif. Ces dernières peuvent par exemple comprendre une étape de formation d'un empilement capacitif par une technique de dépôt en couche atomique (« Atomic Layer Deposition » ou « ALD » selon la terminologie Anglo-Saxonne) sur le réseau de faisceaux de nanotubes. Des étapes de formation d'électrodes et/ou de gravure sont également exécutées. Toutefois, la configuration ou l'agencement des dispositifs capacitifs actuellement considérés ne permet pas de préserver l'intégrité des faisceaux de nanotubes lors de l'exécution du procédé de fabrication.

En outre, le procédé de fabrication des faisceaux de nanotubes, tel que décrit dans le document [1], implique notamment les étapes suivantes :
a0) la fourniture d'un substrat de silicium dont une face principale est recouverte d'une couche de dioxyde de silicium formée par exemple par dépôt en phase vapeur assistée par plasma ;
b0) la formation d'une électrode inférieure par exemple par une technique d'évaporation de titane et/ou de cuivre ;
c0) la formation d'ouvertures traversantes dans l'électrode inférieure, lesdites ouvertures traversantes étant agencées de manière matricielle ;
d0) la formation des faisceaux de nanotubes de carbone selon les conditions décrites dans le document [2] cité à la fin de la description, chaque faisceau prenant naissance au niveau d'une ouverture traversante.

Toutefois, ce procédé de fabrication des faisceaux de nanotubes de carbone n'est pas non plus satisfaisant.

En effet, la formation des ouvertures traversantes nécessite la mise en œuvre d'un masque dur (« hard mask » selon la terminologie Anglo-Saxonne).

Par ailleurs, dans la mesure où il est requis de former des ouvertures de petite dimension et peu espacées les unes des autres, la formation de ces dernières ne peut être mise en œuvre par des techniques photo lithographiques standards et ainsi nécessiter l'emploi d'une gravure ou lithographie par faisceau d'électrons (« Electron Beam Lithography » selon la terminologie Anglo-Saxonne). Cette technique présente une cadence et un coût qui ne sont cependant pas compatibles avec les requis de l'industrie de la micro-électronique.

Le document [2bis] décrit un dispositif capacitif comprenant une couche métallique, un réseau de faisceau de nanotubes et un empilement capacitif recouvrant la couche métallique et les faisceaux de nanotubes.

Ainsi, un but de la présente invention est de proposer un dispositif capacitif qui présente un agencement permettant d'envisager un procédé de fabrication préservant l'intégrité des faisceaux de nanotubes.

Un autre but de la présente invention est de proposer un dispositif capacitif pour lequel le procédé de fabrication est plus simple à mettre en œuvre que les procédés connus de l'état de la technique.

### EXPOSÉ DE L'INVENTION

Les buts de la présente invention sont, au moins en partie, atteints par un dispositif capacitif comprenant :
- une couche métallique pourvue de deux faces principales dites, respectivement, face avant et face arrière ;
- un réseau de faisceaux de nanotubes ou de nanofils qui s'étendent, à partir de la face avant, et de manière essentiellement perpendiculaire à cette dernière, d'un pied vers une extrémité libre ;
- un empilement capacitif continu recouvrant de manière conforme la couche métallique et les faisceaux de nanotubes ou de nanofils de leur pied vers leur extrémité libre, ledit empilement comprenant une couche conductrice supérieure et une couche isolante isolant la couche conductrice supérieure de chaque faisceau de nanotubes et de la couche métallique,

le dispositif comprenant une zone capacitive et une zone de contact inférieur,
la zone capacitive étant une zone au niveau de laquelle la couche conductrice supérieure encapsule les faisceaux de nanotubes ou de nanofils et la couche isolante, tandis que la zone de contact inférieur est une zone au niveau de laquelle d'une part l'empilement capacitif laisse découvertes les extrémités libres, et d'autre part la couche isolante encapsule la couche conductrice supérieure.

Selon un mode de mise en œuvre, ledit dispositif comprend une électrode supérieure en recouvrement de la zone capacitive de manière à contacter électriquement la couche conductrice supérieure.

Selon un mode de mise en œuvre, ledit dispositif comprend une électrode inférieure en recouvrement de la zone de contact inférieur de manière à contacter électriquement les extrémités libres des faisceaux de nanotubes ou de nanofils de la zone de contact inférieur.

Selon un mode de mise en œuvre, l'empilement capacitif comprend, en outre, une couche conductrice inférieure intercalée entre la couche isolante et les faisceaux de nanotubes ou de nanofils, la couche conductrice inférieure encapsulant la couche isolante au niveau de la zone de contact inférieur.

Selon un mode de mise en œuvre, l'électrode inférieure est également en contact électrique avec la couche conductrice inférieure.

Selon un mode de mise en œuvre, la couche conductrice inférieure comprend du nitrure de titane.

Selon un mode de mise en œuvre, la couche conductrice supérieure comprend du nitrure de titane.

Selon un mode de mise en œuvre, la couche isolante comprend de l'alumine.

Selon un mode de mise en œuvre, ledit dispositif comprend également une zone neutre s'interposant entre la zone capacitive et la zone de contact inférieur, et au niveau de laquelle une couche isolante inférieure est intercalée entre la couche métallique et les faisceaux de nanotubes ou de nanofils de ladite zone neutre.

Selon un mode de mise en œuvre, la zone neutre est recouverte d'au moins une couche d'encapsulation faite de matériau isolant.

Selon un mode de mise en œuvre, l'au moins une couche d'encapsulation une couche d'oxyde de silicium et une couche de nitrure de silicium.

Selon un mode de mise en œuvre, les faisceaux de nanotubes ou de nanofils présentent une longueur comprise entre 2 µm et 40 µm, de préférence comprise entre 2 µm et 12 µm.

Selon un mode de mise en œuvre, la couche métallique repose, par une de ses faces opposées à la face avant, sur un substrat support, avantageusement une couche diélectrique est intercalée entre le substrat support et la couche métallique.

L'invention concerne également un procédé de fabrication du dispositif capacitif selon la présente invention, ledit procédé comprenant les étapes suivantes :
a) une étape d'anodisation d'une couche métallique, d'une première épaisseur E1, à partir d'une face avant de ladite couche métallique et sur une deuxième épaisseur E2 inférieure à la première épaisseur, et destinée à former une couche d'oxyde ;
b) une étape de gravure sélective de la couche d'oxyde formée à l'étape a) ;
d) une étape de croissance d'un réseau de faisceaux de nanotubes ou de nanofils
   l'étape a) étant exécutée de sorte que la face exposée de la couche métallique à l'issue de l'étape b) présente une texturation, ladite texturation se matérialisant par la présence d'un réseau de cavités concaves de profondeur moyenne P et de dimension latérale moyenne D, ladite profondeur moyenne P et ladite dimension latérale moyenne D étant ajustées de sorte que chaque faisceau de nanotubes prenne naissance dans une cavité concave et s'étende, à partir de ladite cavité concave d'un pied vers une extrémité libre et de manière essentiellement perpendiculaire à la couche de métallique ;
e) une étape de définition de la zone capacitive, qui comprend la formation d'un empilement d'une première couche diélectrique et d'une deuxième couche diélectrique en recouvrement du réseau de faisceau de nanotube, et la formation d'une première ouverture traversante dans ledit empilement, la première ouverture délimitant la zone de contact ;
f) une étape de formation d'un empilement capacitif continu recouvrant de manière conforme la couche métallique et les faisceaux de nanotubes ou de nanofils de leur pied vers leur extrémité libre, ledit empilement comprenant une couche conductrice supérieure et une couche isolante isolant la couche conductrice supérieure de chaque faisceau de nanotubes et de la couche métallique,
   la couche conductrice supérieure encapsulant les faisceaux de nanotubes ou de nanofils et la couche isolante dans la zone capacitive, tandis dans une zone de contact inférieur, différente de la zone capacitive, l'empilement capacitif laisse découvertes les extrémités libres, et la couche isolante encapsule la couche conductrice supérieure.

### BRÈVE DESCRIPTION DES DESSINS

D'autres caractéristiques et avantages apparaîtront dans la description qui va suivre d'un dispositif capacitif selon l'invention, donnés à titre d'exemples non limitatifs, en référence aux dessins annexés dans lesquels :
La figure 1 est une représentation schématique d'un dispositif capacitif selon un plan de coupe perpendiculaire à une face avant de la couche métallique selon la présente invention.
La figure 2 est une représentation schématique illustrant le détail de l'empilement capacitif au niveau des faisceaux de nanotubes.
La figure 3 est une représentation schématique d'une couche métallique reposant sur un substrat support.
La figure 4 est une illustration d'une étape d'anodisation de la couche métallique selon la présente invention.
La figure 5 est une illustration d'une étape de gravure de la couche d'oxyde formée au cours de la l'étape d'anodisation selon la présente invention.
La figure 6 est une image obtenue au moyen d'un microscope électronique à balayage permettant d'observer une texturation de la face exposée de la couche de matériau conducteur à l'issue de l'étape b) de gravure de la couche d'oxyde selon la présente invention.
La figure 7 est une illustration d'une étape de définition des zones capacitive, neutre et de contact inférieur selon la présente invention.
La figure 8 est une illustration d'une étape de formation d'un réseau de faisceaux de nanotubes selon la présente invention.
La figure 9 est une image obtenue au moyen d'un microscope électronique à balayage permettant d'observer des faisceaux de nanotubes de carbone prenant chacun naissance dans une cuvette et s'étendant de manière essentiellement perpendiculaire à la couche de matériau conducteur.
La figure 10 est une illustration d'une étape d) d'encapsulation du réseau de faisceaux de nanotubes selon la présente invention.
La figure 11 est une illustration de l'enrobage de la fraction protégée des faisceaux de nanotubes par la première couche diélectrique formée lors de l'étape d).
La figure 12 est une illustration de l'étape e) d'exposition à l'environnement extérieur de la zone de contact selon la présente invention.
La figure 13 est une illustration de l'étape f) de formation de l'empilement capacitif selon la présente invention.
La figure 14 est une illustration de l'arrangement de l'empilement capacitif au niveau des extrémités libres des faisceaux de nanotubes dans la zone capacitive et dans la zone neutre.
La figure 15 est une illustration d'une coupe en biais de faisceaux de nanotubes après formation de l'empilement capacitif, les positions A, B, C et D illustrant des hauteurs différentes.
Les figures 16A, 16B, 16C et 16D sont des images obtenues par microscopie électronique à balayage aux positions A, B, C, et D représentées à la figure 15.
La figure 17 est une illustration de l'étape g) de formation de l'électrode supérieure selon la présente invention.
La figure 18 est une illustration de l'étape h) d'exposition à l'environnement extérieur de la zone de contact inférieur selon la présente invention.
La figure 19 est une illustration de l'étape de formation de l'électrode inférieure selon la présente invention.
La figure 20 est une illustration de la prise de contact au niveau de l'électrode supérieure et de l'électrode inférieure selon la présente invention.
La figure 21 est une représentation graphique de la dimension latérale moyenne D des cuvettes (axe vertical, en « nm ») en fonction du potentiel U (axe horizontal, en « V ») appliqué lors de l'étape d'anodisation d'une couche d'aluminium, et présence d'acide phosphorique (points « A »), ou en présence d'acide sulfurique (points « B ») ou en présence d'oxalique (points « C ») ou en présence d'acide sélénique (point « D »).

### EXPOSÉ DÉTAILLÉ DE MODES DE RÉALISATION PARTICULIERS

La présente invention concerne un dispositif capacitif pourvu d'un empilement capacitif déposé de manière conforme à un réseau de faisceaux nanotubes, et notamment de faisceaux de nanotubes de carbone. Les faisceaux de nanotubes s'étendent à cet égard, à partir d'une face avant d'une couche métallique, d'un pied vers une extrémité libre et de manière essentiellement perpendiculaire à ladite face avant.

L'empilement capacitif continu comprend une couche conductrice supérieure et une couche isolante isolant la couche conductrice supérieure de chaque faisceau de nanotubes et de la couche métallique.

L'agencement de l'empilement capacitif permet de définir une zone capacitive et une zone de contact inférieur au sein du dispositif capacitif. Notamment, la zone capacitive est une zone au niveau de laquelle la couche conductrice supérieure encapsule les faisceaux de nanotubes et la couche isolante, tandis la zone de contact inférieur est une zone au niveau de laquelle d'une part l'empilement capacitif laisse découvertes les extrémités libres, et d'autre part la couche isolante encapsule la couche conductrice supérieure.

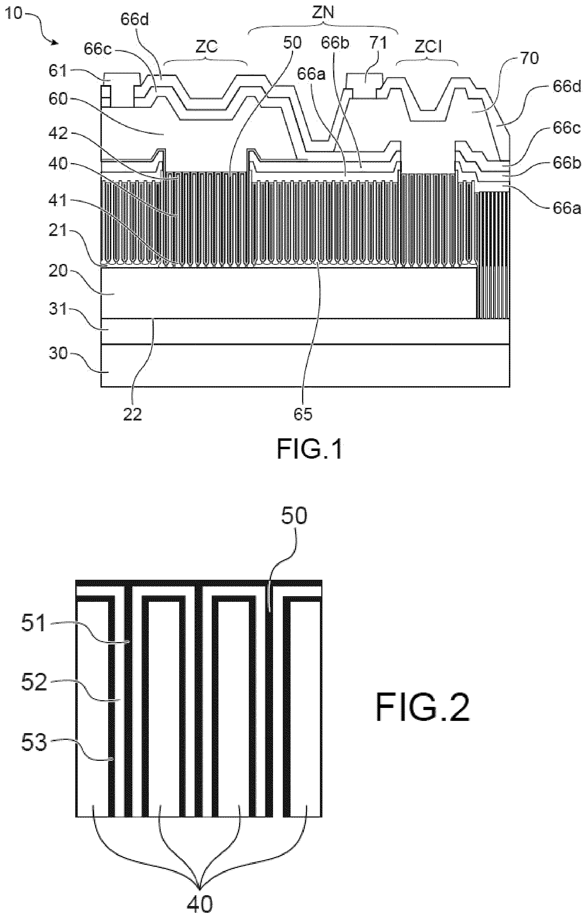

A la figure 1, on peut voir un exemple de dispositif capacitif 10 selon la présente invention.

Le dispositif capacitif 10 est pourvu d'une couche métallique 20 qui comprend une face avant 21 et une face arrière 22 opposée et essentiellement parallèle à la face avant 21.

La couche métallique 20 peut comprendre de l'aluminium ou du cuivre.

La couche métallique 20 peut présenter une épaisseur comprise entre 0,5 µm et 3 µm.

Selon un mode de réalisation particulier, la couche métallique 20 peut reposer, par sa face arrière, sur un substrat support 30. Une couche diélectrique 31 peut avantageusement être intercalée entre le substrat support 30 et la couche métallique 20.

Le dispositif capacitif selon la présente invention comprend également un réseau de faisceaux de nanotubes 40 qui s'étendent, à partir de la face avant 21, et de manière essentiellement perpendiculaire à cette dernière, d'un pied 41 vers une extrémité libre 42.

Par « réseau », on entend un agencement dense de faisceaux de nanotubes, et notamment espacés les uns des autres d'une distance moyenne D comprise entre 50 nm et 500 nm, avantageusement comprise entre 50 nm et 300 nm, et notamment égale à 150 nm.

Par « faisceau de nanotubes », on entend un ensemble de nanotubes, essentiellement parallèles entre eux, et éventuellement entremêlés.

La description ne mentionne que des faisceaux de nanotubes, toutefois, l'invention est également réalisable en mettant en œuvre des nanofils, et plus particulièrement des nanofils de Nickel, de silicium.

Les faisceaux de nanotubes peuvent comprendre des faisceaux de nanotubes de carbone. L'invention n'est toutefois pas limitée à ce seul aspect, et l'homme du métier pourra considérer toute autre espèce susceptible de former des faisceaux de nanotubes.

Les faisceaux de nanotubes peuvent présenter une longueur comprise entre 2 µm et 40 µm, et de préférence entre 2 µm et 12 µm.

Chaque faisceau de nanotubes peut prendre naissance dans une cavité concave formée sur la face avant de la couche métallique. A cet égard, la couche métallique 20 peut présenter sur sa face 21 avant une texturation, ladite texturation se matérialisant par la présence d'un réseau de cavités concaves de profondeur moyenne P et de dimension latérale moyenne D, et à partir desquelles chaque faisceau de nanotubes s'étend. De manière avantageuse, la dimension latérale moyenne D est comprise entre 50 nm et 500 nm, avantageusement comprise entre 50 nm et 300 nm, et notamment égale à 150 nm. Toujours de manière avantageuse, la profondeur moyenne P est comprise entre 10 nm et 20 nm.

La considération d'une texturation prenant la forme de cavités concaves permet ainsi d'envisager un réseau de faisceaux de nanotubes relativement dense, et plus particulièrement d'obtenir un rapport section des faisceaux sur surface occupée de l'ordre de 0,3. Cette densité permet notamment d'obtenir une configuration optimisée dans le cadre des capacités.

Le dispositif capacitif 10 selon la présente invention comprend également un empilement capacitif 50. L'empilement capacitif 50 est continu et recouvre de manière conforme la couche métallique 20 et les faisceaux de nanotubes 40 de leur pied 41 vers leur extrémité libre 42.

En d'autres termes, l'empilement capacitif 50 rempli, au moins partiellement, les espacements entre les faisceaux de nanotubes. Plus particulièrement, l'empilement capacitif 50 recouvre la couche métallique 20 (entre les faisceaux de nanotube) ainsi que les flans des faisceaux de nanotubes.

L'empilement capacitif 50 comprend une couche conductrice supérieure 51 et une couche isolante 52 isolant la couche conductrice supérieure de chaque faisceau de nanotubes 40 et de la couche métallique 20.

La couche isolante 52 peut comprendre de l'alumine (Al₂O₃).

La couche conductrice supérieure 51 peut comprendre du nitrure de titane (TiN).

Le dispositif 10 comprend une zone capacitive ZC et une zone de contact inférieur ZCI.

La zone capacitive ZC est une zone au niveau de laquelle la couche conductrice supérieure 51 encapsule les faisceaux de nanotubes 40 et la couche isolante 52. En d'autres termes, dans cette zone capacitive ZC, les extrémités libres 42 des faisceaux de nanotubes 40 sont recouvertes par la couche conductrice supérieure 51 (étant entendu que, dans cette même zone, la couche isolante 52 est intercalée entre lesdits faisceaux et la couche conductrice supérieure 51). La figure 2 illustre à cet égard l'agencement des couches de l'empilement capacitif 50 au niveau des extrémités libres des faisceaux de nanotubes 40.

Le dispositif capacitif 10 peut comprendre une électrode supérieure 60 en recouvrement de la zone capacitive ZC. L'agencement relatif à la zone capacitive ZC permet ainsi à l'électrode supérieure 60 de contacter électriquement directement la couche conductrice supérieure 51. L'électrode supérieure 60 peut être recouverte d'une ou plusieurs couches de matériau isolant 66c, 66d. Une reprise de contact en la forme d'un plot métallique 61 (« UBM » ou « Upper Bump Metallurgy » selon la terminologie anglo-saxonne) peut être formée au travers de la couche 66c, 66d.

La zone de contact inférieur ZCI est, pour sa part, une zone au niveau de laquelle, d'une part, l'empilement capacitif 50 laisse découvertes les extrémités libres 42, et, d'autre part, la couche isolante 52 encapsule la couche conductrice supérieure 51.

Le dispositif capacitif 10 peut comprendre une électrode inférieure 70 en recouvrement de la zone de contact inférieur ZCI de manière à contacter électriquement les extrémités libres 42 des faisceaux de nanotubes 40 de ladite zone de contact inférieur ZCI. L'encapsulation de la couche conductrice supérieure 51 par la couche isolante 52 permet d'isoler électriquement la couche conductrice supérieure 51 de l'électrode inférieure 70.

L'électrode inférieure 70 peut être recouverte de la couche de matériau isolant 66d. Une reprise de contact en la forme d'un plot métallique 71 (« UBM » ou « Upper Bump Metallurgy » selon la terminologie anglo-saxonne) peut être formée à travers la couche 66d.

Selon une variante avantageuse, l'empilement capacitif peut comprendre une couche conductrice inférieure 53, par exemple en nitrure de titane, intercalée entre la couche isolante et les faisceaux de nanotubes, la couche conductrice inférieure encapsulant la couche isolante au niveau de la zone de contact inférieur. Ainsi, selon cette variante, l'électrode inférieure peut également être en contact électrique avec la couche conductrice inférieure.

Le dispositif capacitif 10 peut également comprendre une zone neutre ZN s'interposant entre la zone capacitive ZC et la zone de contact inférieur ZCl. La zone neutre est notamment caractérisée par la présence d'une couche isolante inférieure 65 intercalée entre la couche métallique 20 et les faisceaux de nanotubes 40.

Dès lors qu'elle est considérée, la zone neutre ZN peut être recouverte d'au moins une couche d'encapsulation 66a, 66b faite de matériau isolant. L'au moins une couche d'encapsulation peut notamment comprendre une couche d'oxyde de silicium 66a et une couche de nitrure de silicium 66b en recouvrement de la couche d'oxyde de silicium 66a.

Le dispositif capacitif 10 ainsi décrit présente un agencement permettant de préserver l'intégrité des faisceaux de nanotubes lors du procédé de fabrication dudit dispositif. Ce procédé, qui fait également partie de l'invention, est décrit dans la suite de l'énoncé.

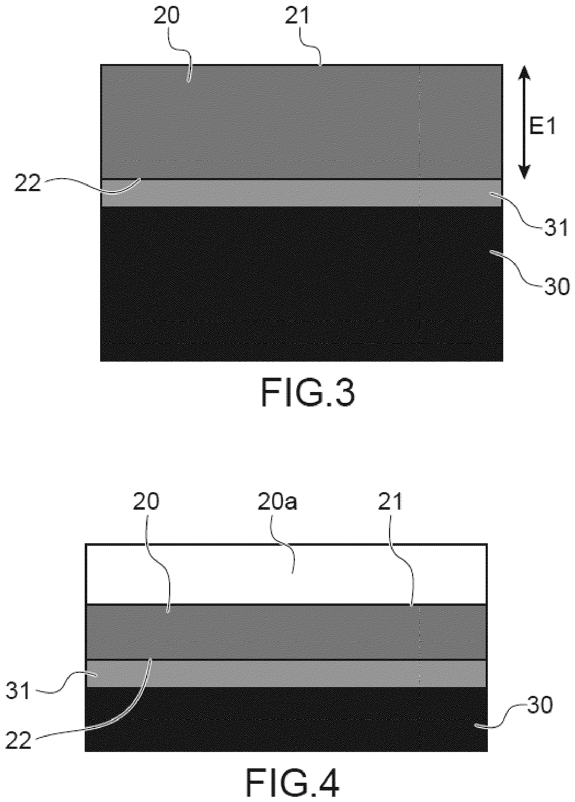

Ainsi, aux figures 3 à 20, on peut voir un exemple de procédé de fabrication du dispositif capacitif selon la présente invention.

Le procédé comprend notamment la fourniture d'une couche métallique 20 pourvue d'une face avant 21 et d'une face arrière 22 essentiellement parallèles (figure 3).

La couche métallique 20 peut comprendre un métal et notamment au moins un des éléments choisis parmi : aluminium, cuivre.

La couche métallique 20 peut présenter une épaisseur initiale, dite première épaisseur E1, supérieure à 1,5 µm, notamment comprise entre 1,5 µm et 4 µm, par exemple égale à 4 µm.

La couche métallique 20 peut reposer par sa face arrière 22 sur un substrat support 30, et notamment un substrat de silicium.

La couche métallique 20 peut être formée par une technique de dépôt ou d'évaporation.

Une couche diélectrique 31, par exemple une couche d'oxyde de silicium 31, peut également être formée avant le dépôt de la couche métallique 20. En d'autres termes, si elle est considérée, la couche diélectrique 31 est intercalée entre la couche métallique 20 et le substrat support 30.

Le procédé selon la présente invention comprend une étape a) d'anodisation illustrée à la figure 4 et destinée à former une couche d'oxyde 20a à partir de la face avant 21 de la couche métallique 20 par oxydation de cette dernière.

L'étape a) d'anodisation peut être mise en œuvre dans un bain d'acide, et notamment dans un bain comprenant au moins l'un des acides choisis parmi : acide sélénique, acide sulfurique, d'acide oxalique ou d'acide phosphatique. Le bain peut à cet égard être maintenu à une température comprise entre 2 °C et 3,5 °C, par exemple égale à 3 °C.

Au cours de cette étape a) d'anodisation, la couche métallique 20 est consommée par oxydation à partir de la face avant 21 sur une deuxième épaisseur E2 inférieure la première épaisseur E1, et de manière à former la couche d'oxyde 20a. La deuxième épaisseur E2 est avantageusement comprise entre 0,5 µm et 3 µm, par exemple 1 µm.

Dans la mesure où l'anodisation d'un métal, et notamment de l'aluminium est connue de l'homme du métier et plus particulièrement présentée dans le document [3] cité à la fin de la description, cette étape n'est pas décrite en détails dans la suite de l'exposé.

L'étape a) d'anodisation est suivie d'une étape b) une étape de gravure liquide, éventuellement sélective de la couche d'oxyde 20a formée à l'étape a).

Par « gravure sélective », on entend une gravure qui grave préférentiellement la couche d'oxyde 20a au regard de la couche métallique 20.A cet égard, si la couche métallique 20 est faite d'aluminium, la couche d'oxyde formée, qui comprend de l'alumine, peut être gravée sélectivement avec l'acide phosphorique, voire de l'acide phosphorique tamponné.

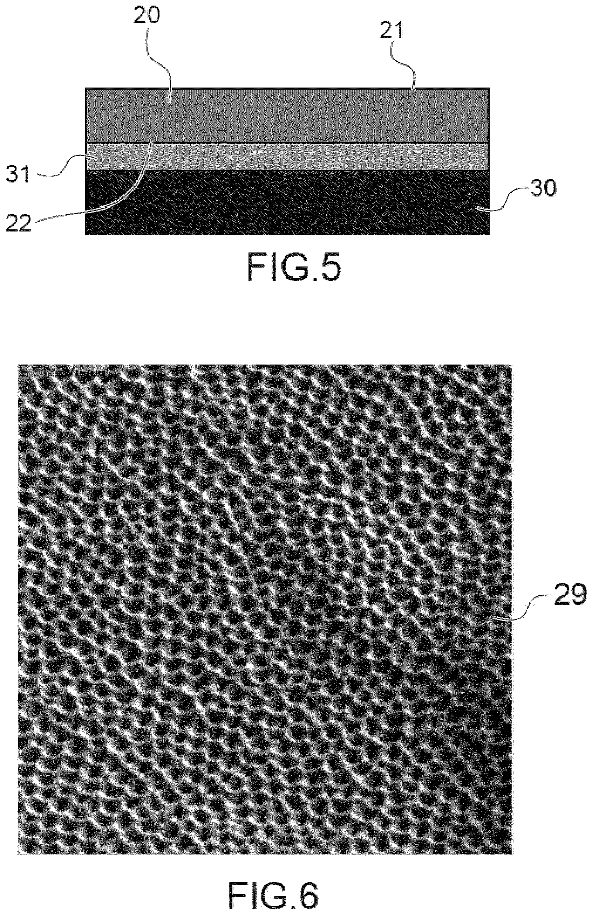

Une observation au microscope électronique à balayage (figure 6) a permis aux inventeurs d'observer une texturation de la face exposée de la couche métallique 20 à l'issue de l'étape b). Cette texturation de la face exposée se traduit notamment par la présence de cuvettes 29 ou de cavités concaves 29.

Par « cuvette » ou « cavités concaves » on entend des creux présents sur la face exposée, et qui présentent une profondeur moyenne P et de dimension latérale moyenne D.

La dimension latérale moyenne D est notamment la dimension d'ouverture des cuvettes.

L'ajustement de ces deux paramètres P et D dépend notamment des conditions imposées lors de l'étape a) d'anodisation de la nature de la couche métallique 20.

L'ajustement des conditions d'anodisation afin d'obtenir des valeurs de P et de D bien définies est la portée de l'homme de métier, et n'est donc pas décrit en détails dans la présente demande de brevet.

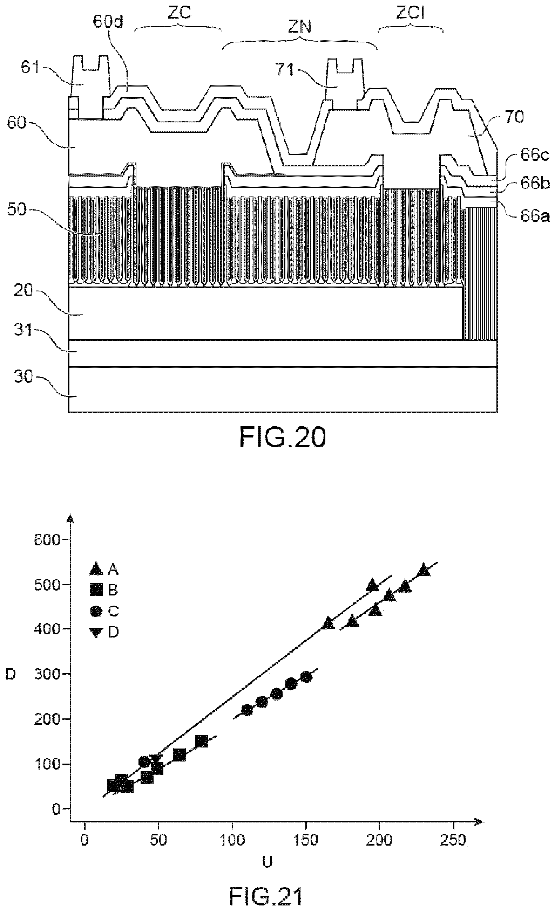

A cet égard, la figure 21 est une représentation graphique de la dimension latérale moyenne D en fonction du potentiel d'anodisation U appliqué pour différents type d'électrolytes. Ce graphique démontre très clairement que D, dépendamment des conditions d'anodisation imposées, peut prendre toutes les valeurs comprises entre 30 nm et 550 nm.

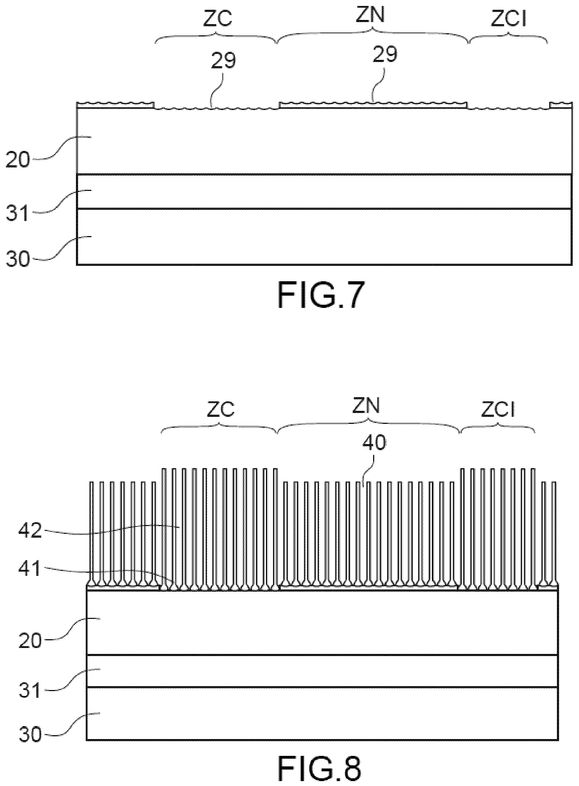

Le procédé selon la présente invention peut également comprendre une étape c) de définition des zones capacitives ZC, de contact inférieur ZCI, et, éventuellement, neutre ZN (figure 7).

L'étape c) peut notamment comprendre les sous-étapes suivantes :
c1) une sous-étape de dépôt conforme d'une couche isolante inférieure,
c2) une étape de photolithographie/gravure destinée à conserver la couche isolante inférieure exclusivement au niveau de la zone neutre ZN.

L'étape c1) peut, à cet égard, comprendre la formation de la couche inférieure isolante, par exemple de l'alumine, par une technique de dépôt en couches atomiques (« ALD » ou « Atomic Layer Deposition » selon la terminologie anglo-saxonne) ou par anodisation de la couche d'aluminium. Cette technique permet de réaliser des couches de manière relativement conforme à la surface sur laquelle elle repose, et ainsi reproduire fidèlement la texturation imposée par la surface de la couche métallique 30, et notamment l'agencement des cavités concaves 29.

La couche isolante inférieure 65 peut par exemple présenter une épaisseur comprise entre 10 nm et 100 nm.

L'étape c) est alors suivie d'une étape d) de croissance de faisceaux de nanotubes 40 (figure 8). Les faisceaux de nanotubes 40 sont formés par des techniques standards.

En particulier, les faisceaux de nanotubes de carbone peuvent être formés par DC-PECVD ou DCVD à une température de l'ordre de 400 °C avec différents précurseurs et catalyseurs. À cet égard, les documents [4], [5], [6] et [7] cités à la fin de la description, décrivent les conditions de croissance de nanotubes de carbone.

Les faisceaux de nanotubes peuvent présenter une longueur moyenne L comprise entre 2 µm et 40 µm, avantageusement comprise entre 2 µm et 12 µm.

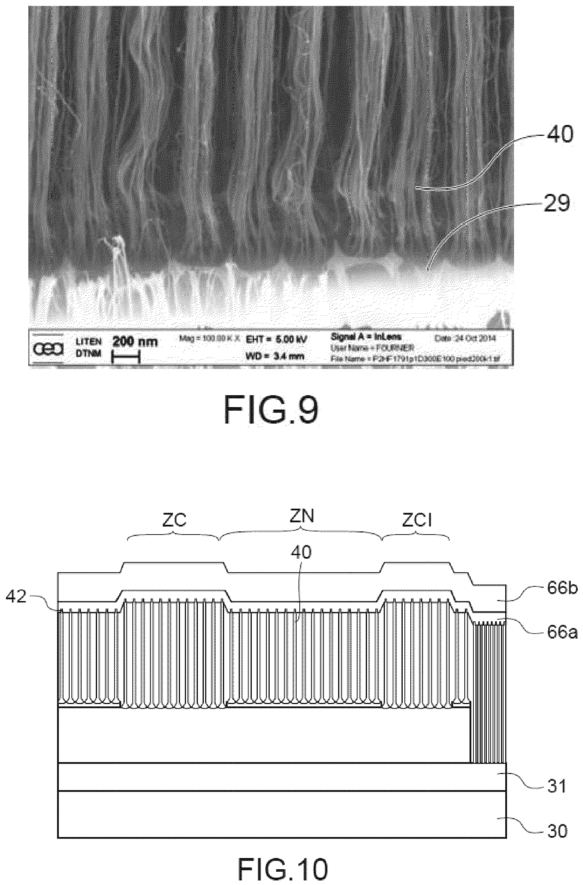

La figure 9 est une observation au microscope électronique à balayage de faisceaux de nanotubes obtenus selon le procédé de la présente invention. Cette image représente clairement des faisceaux de nanotubes 40 agencés en réseau selon une direction essentiellement perpendiculaire à la couche métallique 20, et qui prennent naissance dans une cavité concave 29. À partir de cette observation, les inventeurs ont pu constater que les cavités concaves 29 permettent d'orienter la formation des faisceaux de nanotubes.

Ainsi, selon la présente invention, la profondeur moyenne P et la dimension latérale moyenne D sont ajustées de sorte que chaque faisceau de nanotubes 40 prenne naissance dans une cavité concave 29 et s'étende de manière essentiellement perpendiculaire à la couche métallique 20.

Ainsi, de manière avantageuse, l'étape a) peut être exécutée selon des conditions permettant d'obtenir une dimension latérale moyenne D comprise entre 50 nm et 500 nm, avantageusement comprise entre 50 nm et 300 nm, et notamment égale à 150 nm.

Toujours de manière avantageuse, l'étape a) peut être exécutée selon des conditions permettant d'obtenir une profondeur moyenne P comprise entre 10 nm et 150 nm.

L'étape d) peut être directement suivie d'une étape d1) de traitement plasma des extrémités libres des faisceaux de nanotube 40 de manière à ajuster leur longueur d'extension.

Le procédé selon la présente invention comprend également une étape e) d'encapsulation du réseau.

Cette étape d'encapsulation illustrée à la figure 10 comprend notamment la formation d'une première couche diélectrique 66a suivie de la formation d'une deuxième couche diélectrique 66b en recouvrement du réseau (et plus particulièrement des extrémités libres des faisceaux de nanotubes).

La première couche diélectrique 66a peut comprendre du TEOS et présenter une épaisseur comprise entre 100 et 1000 nm, par exemple égale à 500 nm.

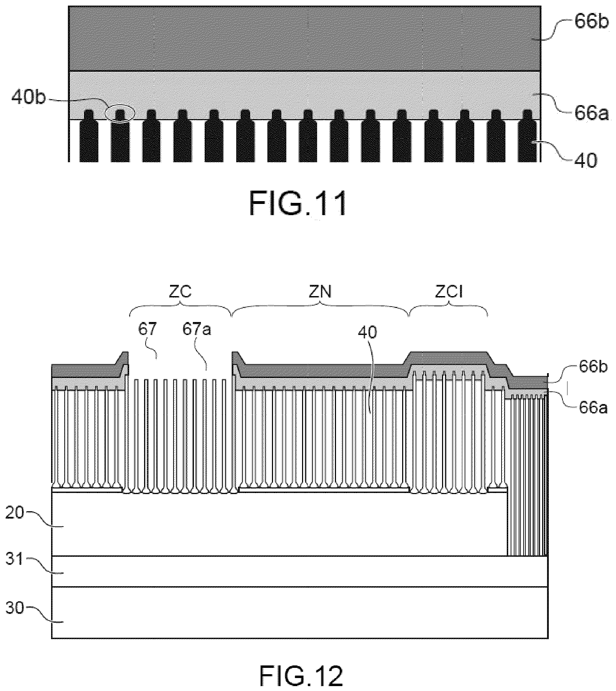

La première couche diélectrique 66a, lors de son dépôt (bien que ce dernier ne soit pas conforme), enrobe une fraction, dite fraction protégée 40b, de chacun des faisceaux de nanotubes qui s'étend à partir de l'extrémité libre 42 desdits faisceaux de nanotubes 40 (figure 11). La formation de la première couche diélectrique 66a peut notamment être exécutée pour que cette fraction n'excède pas 100 nm de longueur. Il est donc entendu que cette fraction est très inférieure à la longueur totale des faisceaux de nanotubes 40.

Le caractère particulièrement avantageux de cet aspect apparaîtra plus clairement dans la suite de la description.

La deuxième couche diélectrique 66b, formée en recouvrement de la première couche diélectrique 66a, peut comprendre du nitrure de silicium et présenter une épaisseur comprise entre 100 nm et 500 nm.

Le procédé selon la présente invention comprend une étape e) d'exposition à l'environnement extérieur de la zone capacitive ZC (figure 12).

Cette étape e) comprend notamment la définition d'un premier motif 67 dans la deuxième couche diélectrique 66b de sorte que cette dernière forme un masque dur. Il est entendu que le premier motif 67 n'est autre qu'une ouverture traversante formée dans la deuxième couche diélectrique 66b. Ce premier motif 67 permet en particulier de délimiter la zone capacitive ZC.

La formation de ce premier motif 67 peut faire intervenir des étapes de photolithographie, de gravure et de retrait de résine photosensible (« stripping » selon la terminologie Anglo-Saxonne).

L'étape e) comprend en outre une gravure, notamment une gravure sèche, destinée à graver la première couche diélectrique 66a à travers le masque dur formé par la deuxième couche diélectrique 66b, de manière à former une première ouverture 67a, conforme au premier motif 67, et ainsi exposer à l'environnement extérieur la zone capacitive ZC.

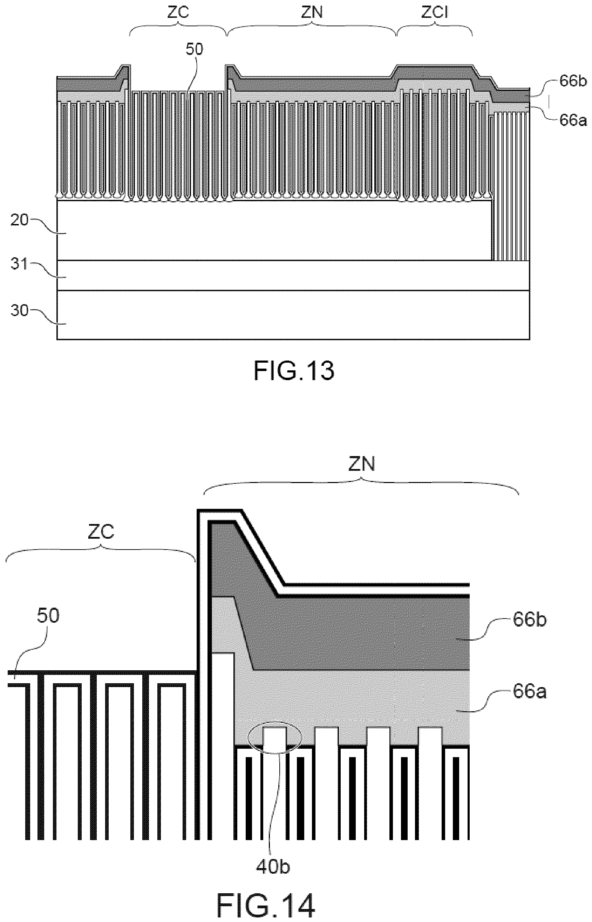

L'étape e) est alors suivie d'une étape f) de formation de l'empilement capacitif 50 par une technique de dépôt en couches atomique (figure 13). Cette technique de dépôt, particulièrement conforme, permet de déposer ledit empilement entre les espaces entre les faisceaux de nanotubes, et plus particulièrement dans les zones neutres et de contact inférieur encore masquées par la première et la deuxième couche diélectrique.

Ainsi, l'étape f) comprend dans l'ordre la formation de la couche conductrice inférieure 53 (cette couche peut toutefois ne pas être considérée dans le cas de structures obtenues avec des matériaux conducteurs), la couche isolante 52, et la couche conductrice supérieure 51.

Il est entendu que l'empilement capacitif, à l'issue de l'étape f) de dépôt conforme, recouvre la couche métallique entre les faisceaux de nanotubes 40, mais également ces derniers de leur pied vers leur extrémité libre.

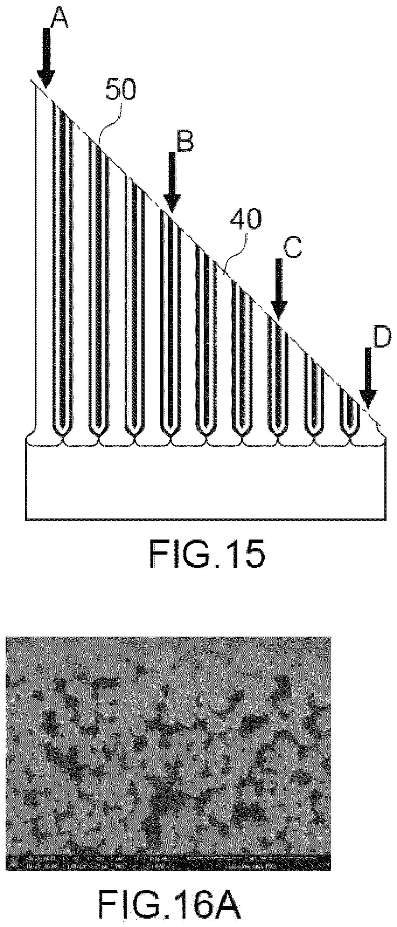

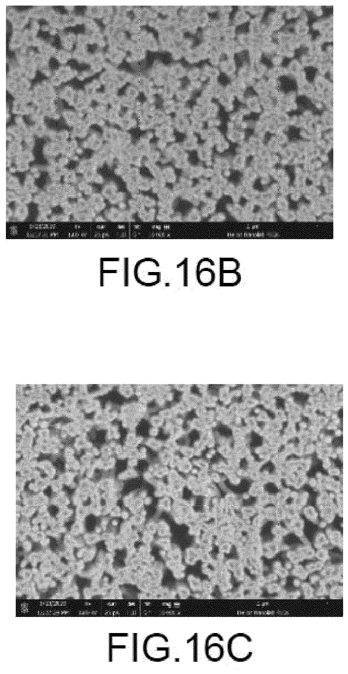

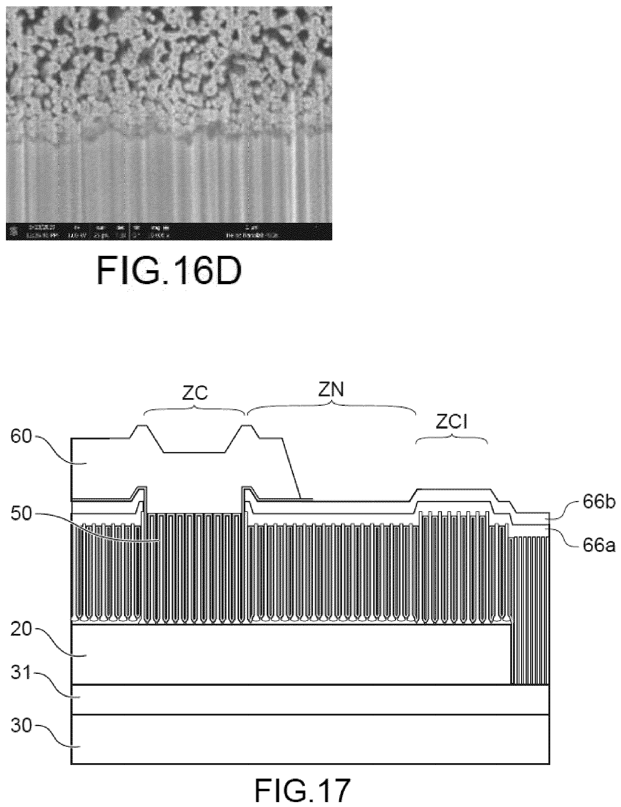

À cet égard, afin de valider le caractère conforme de l'empilement capacitif sur les faisceaux de nanotubes, les inventeurs ont réalisé des observations au microscope électronique à balayage sur des faisceaux de nanotubes aux différentes positions A, B, C, et D illustrées à la figure 15. Les observations au microscope électronique à balayage sont données aux figures 16A, 16B, 16C et 16D. Ces dernières permettent de confirmer la possibilité de former, notamment de manière conforme, l'empilement capacitif 50 sur les faisceaux de nanotubes 40.

La deuxième couche diélectrique 66b, qui n'est pas protégée lors de ce dépôt est également recouverte par l'empilement capacitif 50.

Il est par ailleurs notable qu'au niveau de la zone de contact inférieur ZCI et de la zone neutre ZN, la fraction protégée 40b des faisceaux de nanotubes n'est pas recouverte par l'empilement capacitif 50. Plus particulièrement, dans ces deux zones, la couche isolante 52, et la couche conductrice inférieure 53 (si elle est considérée), viennent encapsuler la couche conductrice supérieure 51.

La figure 14 illustre ainsi l'agencement de l'empilement capacitif 50 formé par la couche conductrice supérieure 51, la couche isolante 52 et la couche conductrice inférieure 53. Ainsi, tel que représenté sur cette figure 14, l'empilement capacitif 50, dans la zone capacitive ZC, enrobe intégralement (notamment les extrémités libres) les faisceaux de nanotubes. A contrario, dans la zone neutre ZN (l'effet est identique dans la zone de contact inférieur ZCI), la fraction protégée est exempte d'empilement capacitif 50. Plus particulièrement, dans cette zone, la couche conductrice supérieure 51 se retrouve complètement encapsulée par la couche isolante 52 et la couche conductrice inférieure 51.

Cet agencement, tel que décrit par la suite, permet de prendre des contacts électriques au niveau, respectivement, de la couche conductrice supérieure 51, et de la couche conductrice inférieure 53 sans exposer les faisceaux de nanotubes 40 à des étapes de procédé susceptibles de les endommager.

Ainsi le procédé selon la présente invention comprend la formation, lors d'une étape g), d'une électrode supérieure 60 en recouvrement de la zone capacitive ZC. L'électrode supérieure 60 peut présenter un léger recouvrement avec les couches 66a et 66b de la zone neutre ZN. La formation de l'électrode supérieure 60 est connue de l'homme du métier et n'est donc pas décrite plus en détails. L'étape g) peut également comprendre le retrait de l'empilement capacitif en recouvrement de la deuxième couche diélectrique 66b après formation de l'électrode supérieure 60. Il est toutefois entendu que la section de l'empilement capacitif recouverte par l'électrode supérieure 60 est conservée.

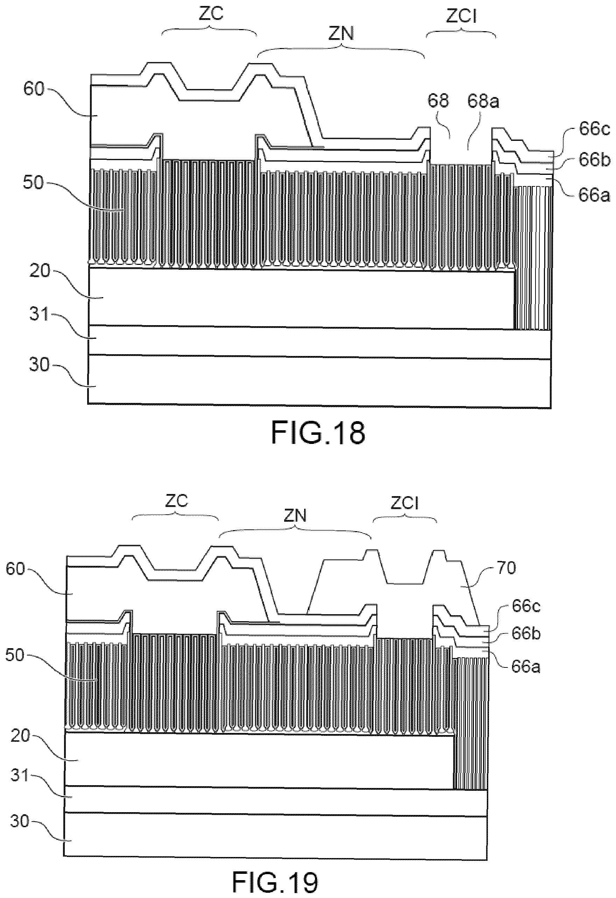

À la figure 18, on peut voir une illustration d'une étape h) destinée à exposer à l'environnement extérieur la zone de contact inférieur ZCI.

Cette étape h) comprend notamment les sous-étapes suivantes :
h1) formation d'une troisième couche diélectrique 66c en recouvrement de l'électrode supérieure et de la deuxième couche diélectrique 66b ;
h2) définition d'un deuxième motif 68 dans la deuxième couche diélectrique 66b et la troisième couche diélectrique de sorte que ces dernières forment un masque dur. Il est entendu que le deuxième motif 68 n'est autre qu'une ouverture traversante formée dans la deuxième couche diélectrique 66b et la troisième couche diélectrique. Ce deuxième motif 68 définit en particulier la zone de contact inférieur ZCI.

La formation de ce deuxième motif 68 peut faire intervenir des étapes de photolithographie, de gravure et de retrait de résine photosensible (« stripping » selon la terminologie Anglo-Saxonne).

L'étape h) comprend en outre une sous-étape h3) de gravure, notamment une gravure sèche, destinée à graver la première couche diélectrique 66a à travers le masque dur formé par la deuxième couche diélectrique 66b et la troisième couche diélectrique, de manière à former une deuxième ouverture 68a, conforme au deuxième motif 68, et ainsi exposer à l'environnement extérieur la zone de contact inférieur ZCI.

L'étape h) est alors suivie de la formation d'une électrode inférieure 70 selon un protocole similaire à celui employé pour la formation de l'électrode supérieure 60 (figure 19).

Enfin, le procédé de fabrication du dispositif capacitif se termine par la formation d'une couche de passivation 66d, et de l'ouverture de cette dernière en deux points de contact de manière à accéder électriquement à l'électrode supérieure 60 et à l'électrode inférieure 70.

Les points de contact sont notamment des plots métalliques 61 et 71 (« UBM » ou « Upper Bump Metallurgy » selon la terminologie Anglo-Saxonne).

### RÉFÉRENCES

[1] A.M. Saleem et al., « Fully solid-state integrated capacitors based on carbon nanofibers and dielectrics with specific capacitances higher than 200 nF/mm2 », IEEE 69th electronic Components and Technology conference, pages 1870-1876, 2019.
[2] A.M. Saleem et al., « Low temperature and cost-effective growth of vertically aligned carbon nanofibers using spin-coated polymer-stabilized palladium nanocatalyst », Sci. Technol. Adv. Mater., vol. 16, no. 1, page 015007, 2015.
   [2bis] US 9 349 789 B1.
[3] Kikuchi Tatsuya et al., « Porous Aluminium Oxide formed by Anodizing in Various Electrolyte Species », Current Nanoscience, 11(5), 560-571, 2015.
[4] J. Dijon et al., « How to switch from a tip to base growth mechanism in carbon nanotube growth by catalytic chemical vapour deposition", Carbon, Vol. 48, Issue 13, pages 3953-3963, 2010.
[5] S. Liatard et al., "Vertically-aligned carbon nanotubes on aluminum as a light-weight positive electrode for lithium-polysulfide batteries", Chem. Commun., 51, 7749, 2015.
[6] US 10370759.
[7] R. Ramos et al., « Nanocarbon interconnects combining vertical CNT interconnects and horizontal graphene lines », IEEE International Interconnect technology conference/Advanced Metallization Conference, 23-26 Mai 2016.

## Revendications

1. Dispositif capacitif (10) comprenant :
- une couche métallique (20) pourvue de deux faces principales dites, respectivement, face avant (21) et face arrière (22) ;
- un réseau de faisceaux de nanotubes ou de nanofils (40) qui s'étendent, à partir de la face avant (21), et de manière essentiellement perpendiculaire à cette dernière, d'un pied (41) vers une extrémité libre (42) ;
- un empilement capacitif (50) continu recouvrant de manière conforme la couche métallique (20) et les faisceaux de nanotubes ou de nanofils (40) de leur pied (41) vers leur extrémité libre (42), ledit empilement comprenant une couche conductrice supérieure (51) et une couche isolante (52) isolant la couche conductrice supérieure (51) de chaque faisceau de nanotubes et de la couche métallique (20),
**Caractérisé en ce que** le dispositif comprend une zone capacitive (ZC) et une zone de contact inférieur (ZCI),
la zone capacitive (ZC) étant une zone au niveau de laquelle la couche conductrice supérieure (51) encapsule les faisceaux de nanotubes ou de nanofils (40) et la couche isolante (52), tandis que la zone de contact inférieur (ZCI) est une zone au niveau de laquelle l'empilement capacitif (50) laisse découvertes les extrémités libres, et la couche isolante (52) encapsule la couche conductrice supérieure (51).

2. Dispositif selon la revendication 1, dans lequel ledit dispositif comprend une électrode supérieure (60) en recouvrement de la zone capacitive (ZC) de manière à contacter électriquement la couche conductrice supérieure (51).

3. Dispositif selon la revendication 1 ou 2, dans lequel ledit dispositif comprend une électrode inférieure (70) en recouvrement de la zone de contact inférieur (ZCI) de manière à contacter électriquement les extrémités libres des faisceaux de nanotubes ou de nanofils (40) de la zone de contact inférieur (ZCI).

4. Dispositif selon l'une des revendications 1 à 3, dans lequel l'empilement capacitif (50) comprend, en outre, une couche conductrice inférieure (53) intercalée entre la couche isolante (52) et les faisceaux de nanotubes ou de nanofils (40), la couche conductrice inférieure (53) encapsulant la couche isolante (52) au niveau de la zone de contact inférieur (ZCI).

5. Dispositif selon les revendications 3 et 4, dans lequel l'électrode inférieure (70) est également en contact électrique avec la couche conductrice inférieure (53).

6. Dispositif selon les revendications 4 ou 5, dans lequel la couche conductrice inférieure (53) comprend du nitrure de titane, la couche conductrice supérieure (51) comprend du nitrure de titane et/ou la couche isolante (52) comprend de l'alumine.

7. Dispositif selon l'une des revendications 1 à 6, dans lequel ledit dispositif comprend également une zone neutre (ZN) s'interposant entre la zone capacitive (ZC) et la zone de contact inférieur (ZCI), et au niveau de laquelle une couche isolante inférieure (65) est intercalée entre la couche métallique (20) et les faisceaux de nanotubes ou de nanofils (40) de ladite zone neutre (ZN).

8. Dispositif selon la revendication 7, dans lequel la zone neutre (ZN) est recouverte d'au moins une couche d'encapsulation (66a, 66b) faite de matériau isolant, .comprenant par exemple une couche d'oxyde de silicium et une couche de nitrure de silicium.

9. Dispositif selon l'une des revendications 1 à 8, dans lequel les faisceaux de nanotubes ou de nanofils (40) présentent une longueur comprise entre 2 µm et 40 µm, de préférence comprise entre 2 µm et 12 µm.

10. Dispositif selon l'une des revendications 1 à 9, dans lequel la couche métallique (20) est une couche d'aluminium d'une épaisseur comprise entre 0,5 µm et 3 µm, et qui présente sur sa face avant (21) une texturation, ladite texturation se matérialisant par la présence d'un réseau de cavités concaves de profondeur moyenne P et de dimension latérale moyenne D, et à partir desquelles chaque faisceau de nanotubes s'étend.

11. Dispositif selon la revendication 10, dans lequel la dimension latérale moyenne D est comprise entre 50 nm et 500 nm, avantageusement comprise entre 50 nm et 300 nm, et notamment égale à 150 nm.

12. Dispositif selon la revendication 10 ou 11, dans lequel la profondeur moyenne P est comprise entre 10 nm et 150 nm.

13. Dispositif selon l'une des revendications 1 à 12, dans lequel les faisceaux de nanotubes (40) sont des faisceaux de nanotubes de carbone.

14. Dispositif capacitif selon l'une des revendications 1 à 13, dans lequel la couche métallique (20) repose, par une de ses faces opposées à la face avant (21), sur un substrat support (30), avantageusement une couche diélectrique (31) est intercalée entre le substrat support (30) et la couche métallique (20).

15. Procédé de fabrication du dispositif capacitif selon l'une des revendications 1 à 14, ledit procédé comprenant les étapes suivantes :
a) une étape d'anodisation d'une couche métallique (20), d'une première épaisseur E1, à partir d'une face avant (21) de ladite couche métallique (20) et sur une deuxième épaisseur E2 inférieure à la première épaisseur, et destinée à former une couche d'oxyde ;
b) une étape de gravure de la couche d'oxyde formée à l'étape a) ;
d) une étape de croissance d'un réseau de faisceaux de nanotubes (40);
l'étape a) étant exécutée de sorte que la face exposée de la couche métallique (20) à l'issue de l'étape b) présente une texturation, ladite texturation se matérialisant par la présence d'un réseau de cavités concaves de profondeur moyenne P et de dimension latérale moyenne D, ladite profondeur moyenne P et ladite dimension latérale moyenne D étant ajustées de sorte que chaque faisceau de nanotubes prenne naissance dans une cavité concave et s'étende, à partir de ladite cavité concave d'un pied (41) vers une extrémité libre (42) et de manière essentiellement perpendiculaire à la couche de métallique ;
e) une étape de définition de la zone capacitive (ZC), qui comprend la formation d'un empilement d'une première couche diélectrique et d'une deuxième couche diélectrique en recouvrement du réseau de faisceau de nanotube, et la formation d'une première ouverture traversante dans ledit empilement, la première ouverture délimitant la zone de contact ;
f) une étape de formation d'un empilement capacitif (50) continu recouvrant de manière conforme la couche métallique (20) et les faisceaux de nanotubes (40) de leur pied (41) vers leur extrémité libre (42), ledit empilement comprenant une couche conductrice supérieure (51) et une couche isolante (52) isolant la couche conductrice supérieure (51) de chaque faisceau de nanotubes et de la couche métallique (20),
la couche conductrice supérieure (51) encapsulant les faisceaux de nanotubes (40) et la couche isolante (52) dans la zone capacitive (ZC), tandis dans une zone de contact inférieur (ZCI), différente de la zone capacitive (ZC), l'empilement capacitif (50) laisse découvertes les extrémités libres, et la couche isolante (52) encapsule la couche conductrice supérieure (51);
g) la formation de l'électrode supérieure (60) au niveau de la zone capacitive (ZC);
h) la formation de l'électrode inférieure (70) au niveau de la zone de contact inférieur (ZCI).

## Patentansprüche

1. Kapazitive Vorrichtung (10), umfassend:
- eine Metallschicht (20) mit zwei Hauptseiten, jeweils Vorderseite (21) und Rückseite (22) genannt;
- ein Netz von Nanoröhrenbündeln oder Nanodrähten (40), die sich von der Vorderseite (21) und im Wesentlichen senkrecht zu dieser von einem Fuß (41) zu einem freien Ende (42) erstrecken;
- ein durchgehender kapazitiver Stapel (50), der die Metallschicht (20) und die Nanoröhrenbündel oder Nanodrähte (40) von ihrem Fuß (41) zu ihrem freien Ende (42) konform abdeckt, wobei der Stapel eine obere leitende Schicht (51) und eine Isolierschicht (52) umfasst, die die obere leitende Schicht (51) jedes Nanoröhrenbündels und der Metallschicht (20) isoliert,
**dadurch gekennzeichnet, dass** die Vorrichtung einen kapazitiven Bereich (KB) und einen unteren Kontaktbereich (UKB) umfasst,
wobei der kapazitive Bereich (KB) ein Bereich ist, in dem die obere leitende Schicht (51) die Nanoröhrenbündel oder Nanodrähte (40) und die Isolierschicht (52) einkapselt, während der untere Kontaktbereich (UKB) ein Bereich ist, in dem der kapazitive Stapel (50) die freien Enden freilässt, und die Isolierschicht (52) die obere leitende Schicht (51) einkapselt.

2. Vorrichtung nach Anspruch 1, wobei die Vorrichtung eine obere Elektrode (60) umfasst, die den kapazitiven Bereich (KB) überlappt, um die obere leitende Schicht (51) elektrisch zu kontaktieren.

3. Vorrichtung nach Anspruch 1 oder 2, wobei die Vorrichtung eine untere Elektrode (70) umfasst, die den unteren Kontaktbereich (UKB) überlappt, um die freien Enden der Nanoröhrenbündel oder Nanodrähte (40) des unteren Kontaktbereichs (UKB) elektrisch zu kontaktieren.

4. Vorrichtung nach einem der Ansprüche 1 bis 3, wobei der kapazitive Stapel (50) ferner eine untere leitende Schicht (53) umfasst, die zwischen die Isolierschicht (52) und die Nanoröhrenbündel oder Nanodrähte (40) eingelegt ist, wobei die untere leitende Schicht (53) die Isolierschicht (52) am unteren Kontaktbereichs (UKB) einkapselt.

5. Vorrichtung nach Anspruch 3 und 4, wobei die untere Elektrode (70) ebenfalls in elektrischem Kontakt mit der unteren leitenden Schicht (53) steht.

6. Vorrichtung nach Anspruch 4 oder 5, wobei die untere leitende Schicht (53) Titannitrid, die obere leitende Schicht (51) Titannitrid und/oder die Isolierschicht (52) Aluminiumoxid umfasst.

7. Vorrichtung nach einem der Ansprüche 1 bis 6, wobei die Vorrichtung auch einen Neutralbereich (NB) umfasst, die zwischen dem kapazitiven Bereich (KB) und dem unteren Kontaktbereich (UKB) liegt, und an der eine untere Isolierschicht (65) zwischen der Metallschicht (20) und die Nanoröhrenbündel oder Nanodrähte (40) des Neutralbereichs (NB) eingelegt ist.

8. Vorrichtung nach Anspruch 7, wobei der Neutralbereich (NB) mit mindestens einer Einkapselungsschicht (66a, 66b) aus Isoliermaterial bedeckt ist, die beispielsweise eine Siliziumoxidschicht und eine Siliziumnitridschicht umfasst.

9. Vorrichtung nach einem der Ansprüche 1 bis 8, wobei die Nanoröhrenbündel oder Nanodrähte (40) eine Länge zwischen 2 µm und 40 µm, vorzugsweise zwischen 2 µm und 12 µm aufweisen.

10. Vorrichtung nach einem der Ansprüche 1 bis 9, wobei die Metallschicht (20) eine Aluminiumschicht mit einer Dicke zwischen 0,5 µm und 3 µm ist und auf ihrer Vorderseite (21) eine Texturierung aufweist, wobei die Texturierung durch das Vorhandensein eines Netzes von konkaven Hohlräumen mit mittlerer Tiefe P und mittlerer seitlicher Abmessung D materialisiert wird, und aus denen sich jedes Nanoröhrenbündel erstreckt.

11. Vorrichtung nach Anspruch 10, wobei die mittlere seitliche Abmessung D zwischen 50 nm und 500 nm, vorteilhafterweise zwischen 50 nm und 300 nm, und insbesondere 150 nm beträgt.

12. Vorrichtung nach Anspruch 10 oder 11, wobei die mittlere Tiefe P zwischen 10 nm und 150 nm liegt.

13. Vorrichtung nach einem der Ansprüche 1 bis 12, wobei die Nanoröhrenbündel (40) Kohlenstoffnanoröhrenbündel sind.

14. Kapazitive Vorrichtung nach einem der Ansprüche 1 bis 13, wobei die Metallschicht (20) durch eine ihrer gegenüberliegenden Seiten der Vorderseite (21) auf einem Trägersubstrat (30) aufliegt, vorteilhafterweise ist eine dielektrische Schicht (31) zwischen dem Trägersubstrat (30) und der Metallschicht (20) eingelegt.

15. Verfahren zur Herstellung der kapazitiven Vorrichtung nach einem der Ansprüche 1 bis 14, wobei das Verfahren die folgenden Schritte umfasst:
a) einen Schritt der Anodisierung einer Metallschicht (20), einer ersten Schicht E1, von einer Vorderseite (21) der besagten Metallschicht (20) und auf einer zweiten Schicht E2, die kleiner als die erste Schicht ist, und zur Bildung einer Oxidschicht;
b) einen Schritt des Ätzens der in Schritt a) gebildeten Oxidschicht;
d) ein Schritt des Wachsens eines Netzes von Nanoröhrenbündeln (40);
Schritt a) so ausgeführt ist, dass die freiliegende Seite der Metallschicht (20) am Ende von Schritt b) eine Texturierung aufweist, wobei die Texturierung durch das Vorhandensein eines Netzes von konkaven Hohlräumen mittlerer Tiefe P und mittlerer Seitenabmessung D materialisiert wird, wobei die mittlere Tiefe P und die mittlere Seitenabmessung D so angepasst sind, dass jeder Nanoröhrenbündel in einem konkaven Hohlraum entsteht und sich aus dem konkaven Hohlraum eines Fußes (41) zu einem freien Ende (42) und im Wesentlichen senkrecht zur Metallschicht erstreckt;
e) einen Schritt der Definition des kapazitiven Bereichs (KB), der die Bildung eines Stapels einer ersten dielektrischen Schicht und einer zweiten dielektrischen Schicht umfasst, die das Netz von Nanoröhrenbündeln überlappt, und die Bildung einer ersten Durchgangsöffnung in dem Stapel, wobei die erste Öffnung den Kontaktbereich begrenzt;
f) einen Schritt der Bildung eines durchgehenden kapazitiven Stapels (50), der die Metallschicht (20) und die Nanoröhrenbündel (40) von ihrem Fuß (41) zu ihrem freien Ende (42) konform abdeckt, wobei der Stapel eine obere leitende Schicht (51) und eine Isolierschicht (52) umfasst, die die obere leitende Schicht (51) jedes Nanoröhrenbündels und der Metallschicht (20) isoliert,
die obere leitende Schicht (51), die die Nanoröhrenbündel (40) und die Isolierschicht (52) in dem kapazitiven Bereich (KB) einkapselt, während in einem unteren Kontaktbereich (UKB), die sich von dem kapazitiven Bereich (KB) unterscheidet, der kapazitive Stapel (50) die freien Enden freilässt, und die Isolierschicht (52) die obere leitende Schicht (51) einkapselt;
g) Bildung der oberen Elektrode (60) an dem kapazitiven Bereich (KB);
h) die Bildung der unteren Elektrode (70) am unteren Kontaktbereich (UKB).

## Claims

1. Capacitive device (10) comprising:
- a metallic layer (20) provided with two principal faces, called the front face (21) and the back face (22) respectively;
- a network of nanotube or nanowire bundles (40) that extend from the front face (21), and substantially perpendicular to the front face, from a base (41) towards a free end (42);
- a continuous capacitive stack (50) covering the metallic layer (20) and the nanotube or nanowire bundles (40) in a conforming manner from their base (41) to their free end (42), said stack comprising an upper conducting layer (51) and an insulating layer (52) insulating the upper conducting layer (51) from each nanotube bundle and from the metallic layer (20),
**Characterized in that** the device comprises a capacitive zone (ZC) and a lower contact zone (ZCI),
the capacitive zone (ZC) being a zone in which the upper conducting layer (51) encapsulates the nanotube or nanowire bundles (40) and the insulating layer (52), while the lower contact zone (ZCl) is a zone in which the capacitive stack (50) leaves the free ends exposed, and the insulating layer (52) encapsulates the upper conducting layer (51).

2. Device according to claim 1, wherein said device comprises an upper electrode (60) covering the capacitive zone (ZC) so as to electrically contact the upper conducting layer (51).

3. Device according to claim 1 or 2, wherein said device comprises a lower electrode (70) covering the lower contact zone (ZCl) so as to electrically contact the free ends of the nanotube or nanowire bundles (40) in the lower contact zone (ZCI).

4. Device according to any of claims 1 to 3, wherein the capacitive stack (50) also comprises a lower conducting layer (53) intercalated between the insulating layer (52) and the nanotube or nanowire bundles (40), the lower conducting layer (53) encapsulating the insulating layer (52) in the lower contact zone (ZCI).

5. Device according to claims 3 and 4, wherein the lower electrode (70) is also in electrical contact with the lower conducting layer (53).

6. Device according to any of claims 4 or 5, wherein the lower conducting layer (53) comprises titanium nitride, the upper conducting layer (51) comprising titanium nitride and/or the insulating layer (52) comprises alumina.

7. Device according to any of claims 1 to 6, wherein said device also comprises a neutral zone (ZN) interposed between the capacitive zone (ZC) and the lower contact zone (ZCI), and in which a lower insulating layer (65) is intercalated between the metallic layer (20) and the nanotube or nanowire bundles (40) in said neutral zone (ZN).

8. Device according to claim 7, wherein the neutral zone (ZN) is covered by at least one encapsulation layer (66a, 66b) made of an insulating material, comprising for example a silicon oxide layer and a silicon nitride layer.

9. Device according to any of of claims 1 to 8, wherein the length of the nanotube or nanowire bundles (40) is between 2 µm and 40 µm, and preferably between 2 µm and 12 µm.

10. Device according to any of claims 1 to 9, wherein the metallic layer (20) is an aluminium layer with a thickness of between 0.5 µm and 3 µm, textured on its front face (21), said texture being materialised by the presence of a network of concave cavities with an average depth P and an average lateral dimension D, starting from which each nanotube bundle extends.

11. Device according to claim 10, wherein the average lateral dimension D is between 50 nm and 500 nm, advantageously between 50 nm and 300 nm, and particularly equal to 150 nm.

12. Device according to claim 10 or 11, wherein the average depth P is between 10 nm and 150 nm.

13. Device according to any of the claims 1 to 12, wherein the nanotube bundles (40) are carbon nanotube bundles.

14. Capacitive device according to any of the claims 1 to 13, wherein the metallic layer (20) is supported through one of its faces opposite the front face (21), on a support substrate (30), advantageously a dielectric layer (31) is intercalated between the support substrate (30) and the metallic layer (20).

15. Method of manufacturing the capacitive device according to any of the claims 1 to 14, said method comprising the following steps:
a) an anodisation step of a metallic layer (20) with a first thickness E1, starting from a front face (21) of said metallic layer (20) and over a second thickness E2 less than the first thickness, and that will form an oxide layer;
b) an etching step of the oxide layer formed in step a)
d) a step of growth of a network of nanotube bundles (40);
step a) being executed such that the exposed face of the metallic layer (20) after step b) is textured, said texture being materialised by the presence of a network of concave cavities with average depth P and average lateral dimension D, said average depth P and said average lateral dimension D being adjusted such that each nanotube bundle initiates in a concave cavity and extends from said concave cavity from a base (41) towards a free end (42) substantially perpendicular to the metallic layer;
e) a definition step of the capacitive zone (ZC) that comprises the formation of a stack of a first dielectric layer and a second dielectric layer covering the network of nanotube bundles, and the formation of a first through opening in said stack, the first opening delimiting the contact zone;
f) a formation step of a continuous capacitive stack (50) covering the metallic layer (20) and the nanotube bundles (40) from their base (41) to their free end (42) in a conforming manner, said stack comprising an upper conducting layer (51) and an insulating layer (52) insulating the upper conducting layer (51) from each nanotube bundle and the metallic layer (20),
the upper conducting layer (51) encapsulating the nanotube bundles (40) and the insulating layer (52) in the capacitive zone (ZC), while in a lower contact zone (ZCl) different from the capacitive zone (ZC), the capacitive stack (50) leaves the free ends exposed, and the insulating layer (52) encapsulates the upper conducting layer (51);
g) the formation of the upper electrode (60) in the capacitive zone (ZC);
h) the formation of the lower electrode (60) in the lower contact zone (ZCI).
